# EUROPEAN PATENT APPLICATION

(11) **EP 2 998 968 A1**
(43) Date of publication of application: **23.03.2016**
(21) Application number: 14798409.0
(22) Date of filing: 31.01.2014
(51) Int. Cl.: H01B 1/22, B22F 7/04, B22F 9/00, C09D 5/24, C09D 7/12, H01B 1/02, H01B 5/14, H01B 13/00, H05K 1/09, H05K 3/10

(54) **COPPER-FINE-PARTICLE DISPERSION LIQUID, CONDUCTIVE-FILM FORMATION METHOD, AND CIRCUIT BOARD**

(30) Priority: 14.05.2013 JP 2013101769
(71) Applicant: Ishihara Chemical Co., Ltd., Kobe-shi Hyogo 652-0806 (JP)
(72) Inventor: KAWATO, Yuichi, Kobe-shi Hyogo 652-0806 (JP); ARIMURA, Hidetoshi, Kobe-shi Hyogo 652-0806 (JP); KUDO, Tomio, Kobe-shi Hyogo 652-0806 (JP)
(74) Representative: Hoefer & Partner Patentanwälte mbB
(86) International application number: PCT/JP2014/052221
(87) International publication number: WO 2014/185101

(57) **Abstract**

[Technical Problem]

To provide copper particulate dispersion capable of forming a conductive film having favorable adhesiveness on an inorganic substrate by photo-sintering.

[Solution to Problem]

The copper particulate dispersion 1 includes a dispersion vehicle and copper particulates 11. The copper particulates 11 are dispersed into the dispersion vehicle. The copper particulate dispersion 1 includes an adhesion improvement agent for improving adhesiveness between a conductive film 4 formed on a substrate by photo-sintering the copper particulate 11 and the substrate. The substrate is an inorganic substrate 3. The adhesion improvement agent is a compound containing a phosphorus atom. Thus, the adhesion improvement agent improves adhesiveness between the conductive film 4 and the inorganic substrate 3.

## Description

### [Technical Field]

The present invention relates to copper particulate dispersion, a conductive film forming method using the copper particulate dispersion, and a circuit board produced by using the conductive film forming method.

### [Background Art]

Conventionally, there is a printed circuit board in which a copper foil circuit is formed on a substrate by photolithography. Photolithography requires a step of etching copper foil, which incurs the cost of, for example, treating wastewater generated by etching.

As a technique which does not require the etching, there is a known method including coating a coating liquid obtained by dispersing metal particulates into a solvent (dispersion vehicle) on a surface of an object on which a film is to be formed and forming a metal film (conductive film) by melting the metal particulates through irradiation of the coating liquid with light (see Patent Literature 1, for example). In this method, the metal particulates are an Ag powder or an ITO powder, which are photo-sintered by the light irradiation.

In the above-described method, a material which is resistant to heat generated from the metal particulates by absorption of energy of the light is used as the material of the film formation object. However, in the case of using copper particulates as the metal particulates and using an inorganic substrate such as glass as the film formation object, the inorganic substrate endures the heat generated by the copper particulate, but it is difficult to attain satisfactory adhesiveness between a conductive film formed by the photo-sintering and the inorganic film.

### [Citation List]

### [Patent Literature]

Patent Literature 1: JP 2004-277832 A

### [Summary of the Invention]

### [Technical Problem]

The present invention solves the above-described problem, and an object thereof is to provide copper particulate dispersion which is capable of forming a conductive film which has favorable adhesiveness on an inorganic substrate by photo-sintering, a conductive film forming method using the copper particulate dispersion, and a circuit board produced by employing the conductive film forming method.

### [Solution to Problem]

The copper particulate dispersion of the present invention comprises a dispersion vehicle and copper particulates dispersed into the dispersion vehicle, characterized in that: the copper particulate dispersion comprises an adhesion improvement agent which improves adhesiveness between a conductive film formed on a substrate by photo-sintering the copper particulates and the substrate; the substrate is an inorganic substrate; and the adhesion improvement agent is a compound containing a phosphorus atom.

In the copper particulate dispersion, the inorganic substrate may preferably be selected from the group consisting of glass, ceramics, a silicon wafer, and aluminum.

In the copper particulate dispersion, the adhesion improvement agent may preferably be added to the dispersion vehicle.

In the copper particulate dispersion, the adhesion improvement agent may preferably be selected from the group consisting of hydroxyethylidene diphosphonic acid, ethylenediaminetetramethylene phosphonic acid, phosphoric acid, tetrabutylphosphonium sulfate, octylphosphonic acid, and a polymer containing a phosphorus atom.

In the copper particulate dispersion, the adhesion improvement agent may preferably have a function of dispersing the copper particulates into the dispersion vehicle.

In the copper particulate dispersion, the adhesion improvement agent may preferably be selected from the group consisting of phosphoric acid esters and high molecular weight phosphoric acid esters.

In the copper particulate dispersion, the dispersion vehicle may comprise a compound containing a phosphorus atom.

The conductive film forming method of the present invention is characterized by comprising a step for forming a film of the copper particulate dispersion on an inorganic substrate and a step for forming a conductive film by photo-sintering the copper particulates in the film through irradiation of the film with light.

The circuit board of the present invention is characterized by comprising a circuit which comprises a conductive film formed by the conductive film forming method on a board comprising an inorganic substrate.

### [Advantageous Effects of Invention]

The copper particulate dispersion of the present invention realizes formation of a conductive film having favorable adhesiveness on an inorganic substrate by photo-sintering since the adhesion improvement agent improves adhesiveness between the conductive film and the inorganic substrate.

### [Brief Description of Drawing]

[Fig. 1]

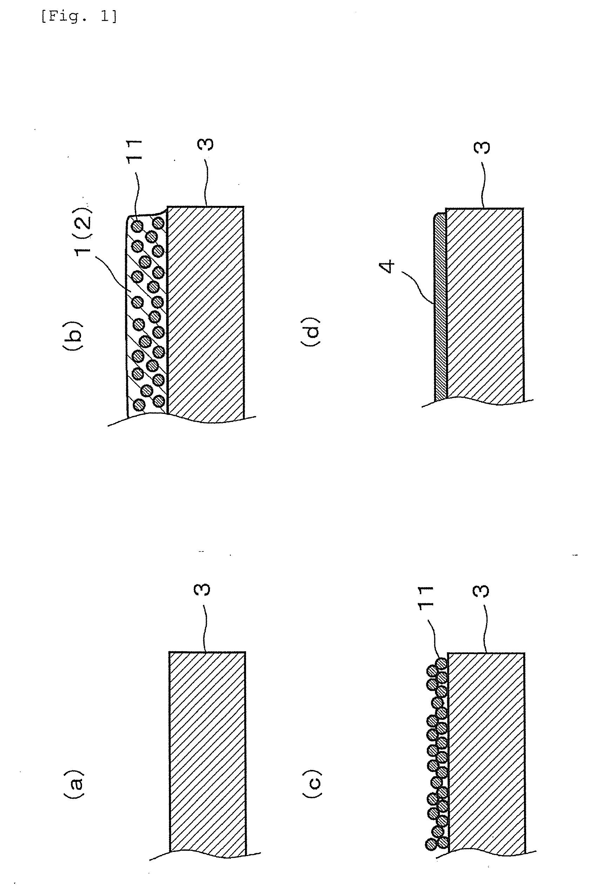

Figs. 1 (a) to (d) are cross-sectional schematic diagrams that show the formation of a conductive film in chronological order using the copper particulate dispersion according to one embodiment of the present invention.

### [Description of Embodiments]

Copper particulate dispersion according to one embodiment of the present invention is described. The copper particulate dispersion comprises a dispersion vehicle and copper particulates. The copper particulates are dispersed into the dispersion vehicle. The copper particulate dispersion comprises an adhesion improvement agent. The adhesion improvement agent is used for improving adhesiveness (also called close-contact property) between a conductive film formed on a substrate by photo-sintering the copper particulate and the substrate. The substrate is an inorganic substrate or a substrate containing an inorganic material. The adhesion improvement agent is a compound containing a phosphorus atom.

The inorganic substrate may be, but is not limited to, glass, ceramics, a silicon wafer, aluminum, or the like. The substrate containing the inorganic material is, for example, an organic-inorganic composite material such as glass epoxy.

In the present embodiment, the copper particulates are particles of copper having an average particle diameter of about 20 nm or more and about 1500 nm or less. The particle diameter of the copper particulates is not limited insofar as the copper particulates are dispersed into the dispersion vehicle. Copper particulates having identical average particle diameter may be used alone, or copper particulates having two or more average particle diameters may be mixed to be used. The copper particulate dispersion is a dispersion-in-liquid system in which the copper particulates are dispersed into the dispersion vehicle. The dispersion vehicle may be, but is not limited to, ethylene glycol, diethylene glycol, or the like.

The adhesion improvement agent is added to the dispersion vehicle, for example. The adhesion improvement agent may be added during production of the copper particulate dispersion or may be added after the production and before use of the copper particulate dispersion. Examples of the adhesion improvement agent include, but are not limited to, hydroxyethylidene diphosphonic acid, ethylenediaminetetramethylene phosphonic acid, phosphoric acid, tetrabutylphosphonium sulfate, octylphosphonic acid, and a polymer containing a phosphorus atom. The adhesion improvement agent may be used singly or in combination of two or more kinds thereof as necessary.

In the present embodiment, a dispersant is added to the dispersion vehicle. The dispersant causes the copper particulates to be dispersed into the dispersion vehicle. In the case where the copper particulates are dispersed without using the dispersant, the dispersant is not necessarily added.

An adhesion improvement agent having a function of dispersing the copper particulates into the dispersion vehicle may be used. In this case, the adhesion improvement agent serves also as the dispersant. Such an adhesion improvement agent may be, but is not limited to, a phosphoric acid ester, a high molecular weight phosphoric acid ester, or the like.

The dispersion vehicle may comprise a compound containing a phosphorus atom. In this case, the dispersion vehicle serves also as the adhesion improvement agent.

A conductive film forming method using the copper particulate dispersion of the present embodiment will be described with reference to Figs. 1(a) to 1(d). As shown in Fig. 1(a) and Fig. 1(b), a film 2 comprising copper particulate dispersion 1 is formed on an inorganic substrate 3. In the film 2, copper particulates 11 are dispersed. The film 2 is formed by a printing method, for example. In the printing method, the copper particulate dispersion 1 is used as an ink for printing, and a predetermined pattern is printed on an object by a printing apparatus to form the film 2 having the pattern. The printing apparatus may be a screen printing machine, an inkjet printer, or the like. The film 2 may be formed by spin coating or the like.

Next, the film 2 is dried. As shown in Fig. 1(c), the film 2 is dried so that a liquid component in the film 2 is evaporated, and the copper particulates 11 and an adhesion improvement agent remain in the film 2. A drying time of the film 2 is varied depending on a dispersion vehicle and is generally terminated within 30 minutes under a 100°C air atmosphere. The step of drying the film 2 may be omitted in some cases.

In the next step, the dried film 2 is irradiated with light. By the light irradiation, the copper particulates 11 in the film 2 are photo-sintered. The copper particulates 11 are molten by the photo-sintering to be welded to the inorganic substrate 3. The photo-sintering is performed under the atmosphere and at a room temperature. A light source used in the photo-sintering may be a xenon lamp, for example. A laser device may be used as the light source. An energy range of the light irradiated from the light source may be 0.1 J/cm² or more and 100 J/cm² or less. An irradiation time may be 0.1 ms or more and 100 ms or less. A number of irradiation times may be one or a plurality of times which is performed by multistage irradiation. The irradiation may be performed for a plurality of times by varying the light energy. The light energy and the number of irradiation times are not limited to these values. As shown in Fig. 1(d), a conductive film 4 is formed by the photo-sintering of the copper particulates 11. A mode of the conductive film 4 thus formed is a continuous film. In the case where the drying of the film 2 is omitted before the light irradiation, the film 2 is dried by the light irradiation at the same time when the copper particulates 11 in the film 2 are photo-sintered.

In the case of using the copper particulate dispersion 1 comprising a compound containing a phosphorus atom (adhesion improvement agent), the conductive film 4 formed by the photo-sintering has favorable adhesiveness to the inorganic substrate 3. The composition of the copper particulate dispersion 1 was discovered through many experiments conducted by the inventor of the present invention. The favorable adhesiveness between the conductive film 4 and the inorganic substrate 3 is generally attributable to the following actions. When the copper particulates 11 are photo-sintered, at least a part of the adhesion improvement agent is heat-decomposed or photo-decomposed to generate a phosphorus atom (P). The phosphorus atom is immediately oxidized so that an oxide of phosphor is generated. The oxygen oxidizing the phosphorus atom exists on a surface oxidized film of the copper particulates 11 and in the air. P₂O₅ which is one of oxides of phosphor is a glass-forming oxide. The glass formed by P₂O₅ is categorized into low melting point glass. The low melting point glass causes a metal to adhere to glass or the like. Therefore, P₂O₅ functions as an adhesive agent to improve adhesiveness between the conductive film 4 and the inorganic substrate 3. The above-described action is one example of theories that explains the experiment result and does not limit the copper particulate dispersion 1.

A circuit board produced by employing the above-described conductive film forming method will be described. The circuit board has a circuit on a board. The board is obtained by forming the inorganic substrate 3 such as glass and ceramics into a plate. The circuit has the conductive film 4 formed by the conductive film forming method. The conductive film 4 forms a conductive wire which electrically connects circuit elements to each other, for example. The conductive film 4 may form the circuit element or a part of the circuit element, such as a coil and electrodes of a capacitor.

According to the copper particulate dispersion 1 according to the present embodiment, since the adhesion improvement agent which is the compound containing phosphorus atom improves adhesiveness between the conductive film 4 and the inorganic substrate 3, the conductive film 4 having favorable adhesiveness can be formed on the inorganic substrate 3 by photo-sintering. Also, by using the copper particulate dispersion 1, the conductive film 4 having favorable adhesiveness can be formed on the circuit board comprising the inorganic substrate 3.

Copper particulate dispersions 1 as Examples of the present invention and copper particulate dispersions for comparison were produced. By using each of the copper particulate dispersions, a conductive film 4 was formed on an inorganic substrate 3. Of each of the formed conductive films 4, electric resistance was measured, and adhesiveness was evaluated.

### [Example 1]

Copper particulate dispersion in which copper particulates were dispersed into a dispersion vehicle was prepared by adding a dispersant. Diethylene glycol was used as the dispersion vehicle. A high molecular weight phosphoric acid ester ("DISPERBYK [registered trademark]-111" [trade name] manufactured by BYK-Chemie) was used as the dispersant. The dispersant was a compound containing a phosphorus atom and serves also as the adhesion improvement agent. A concentration of the adhesion improvement agent (dispersant) was 1 mass% relative to the copper particulate dispersion. The dispersion vehicle was the remnant. An average particle diameter of the copper particulates was 50 nm, and a concentration of the copper particulates was 40 mass%. As a board comprising an inorganic substrate, a glass board ("EAGLE XG" [registered trademark] [trade name] manufactured by Corning Incorporated) was used.

The copper particulate dispersion was coated on the board by spin coating to form a film having a film thickness of 1 µm. The film was irradiated with light to achieve photo-sintering of the copper particulates in the film. Energy of the light irradiation was 11 J/cm². By the photo-sintering, a conductive film was formed on the board.

Sheet resistance was measured as the electric resistance of the formed conductive film. The sheet resistance of the conductive film was as low as 350 mΩ/sq. The adhesiveness of the conductive film was evaluated by conducting a peel test. The peel test conformed to the cross-cut testing method of JIS K5600. In the peel test, the conductive film was not peeled off.

### [Example 2]

Copper particulates having an average particle diameter of 70 nm was used. As the dispersant, a high molecular weight phosphoric acid ester ("DISPERBYK [registered trademark]-102" [trade name] manufactured by BYK-Chemie) which was different from Example 1 was used. The dispersant served also as the adhesion improvement agent. A conductive film was formed on a board under the same conditions as Example 1 except for the above-described changes. The conductive film thus formed had sheet resistance of 350 mΩ/sq. The conductive film was not peeled off in the peel test.

### [Example 3]

A concentration of the copper particulate was changed to 45 mass%. As the dispersant, polyoxyethylene tridecyl ether phosphate ester ("PLYSURF [registered trademark] A212C" [trade name] manufactured by Dai-ichi Kogyo Seiyaku Co., Ltd.) was used. The dispersant served also as the adhesion improvement agent. A concentration of the adhesion improvement agent (dispersant) was 2 mass%. A conductive film was formed on a board under the same conditions as Example 2 except for the above-described changes. The conductive film thus formed had sheet resistance of 300 mΩ/sq. The conductive film was not peeled off in the peel test.

### [Example 4]

As the dispersant, a phosphoric acid ester ("PLYSURF [registered trademark] AL" [trade name] manufactured by Dai-ichi Kogyo Seiyaku Co., Ltd.) which was different from Example 3 was used. The dispersant served also as the adhesion improvement agent. A conductive film was formed on a board under the same conditions as Example 3 except for the above-described change. The conductive film thus formed had sheet resistance of 300 mΩ/sq. The conductive film was not peeled off in the peel test.

### [Example 5]

Polyvinyl pyrrolidone ("PVP K25" [trade name]) was used as the dispersant. A concentration of the dispersant was 2 mass% relative to the copper particulate dispersion. A solution of hydroxyethylidene diphosphonic acid (60 mass%) was added to the dispersion vehicle as the adhesion improvement agent. A concentration of the adhesion improvement agent was 5 mass%. A conductive film was formed on a board under the same conditions as Example 1 except for the above-described changes. The conductive film thus formed had sheet resistance of 290 mΩ/sq. The conductive film was not peeled off in the peel test.

### [Example 6]

A solution of ethylenediaminetetramethylene phosphonic acid (90 mass%) was added to the dispersion vehicle as the adhesion improvement agent. A conductive film was formed on a board under the same conditions as Example 5 except for the above-described change. The conductive film thus formed had sheet resistance of 310 mΩ/sq. The conductive film was not peeled off in the peel test.

### [Example 7]

A solution of phosphoric acid (100 g/L) was added to the dispersion vehicle as the adhesion improvement agent. A conductive film was formed on a board under the same conditions as Example 6 except for the above-described change. The conductive film thus formed had sheet resistance of 290 mΩ/sq. The conductive film was not peeled off in the peel test.

### [Example 8]

A solution of tetrabutylphosphonium sulfate (80 mass%) was added to the dispersion vehicle as the adhesion improvement agent. A conductive film was formed on a board under the same conditions as Example 7 except for the above-described change. The conductive film thus formed had sheet resistance of 300 mΩ/sq. The conductive film was not peeled off in the peel test.

### [Example 9]

A solution of octylphosphonic acid (80 mass%) was added to the dispersion vehicle as the adhesion improvement agent. A conductive film was formed on a board under the same conditions as Example 8 except for the above-described change. The conductive film thus formed had sheet resistance of 320 mΩ/sq. The conductive film was not peeled off in the peel test.

### [Example 10]

Copper particulates having an average particle diameter of 20 nm were used. The dispersant which was the same as that of Example 9 was added to the dispersion vehicle. Further, a high molecular weight phosphoric acid ester ("DISPERBYK [registered trademark]-102" [trade name] manufactured by BYK-Chemie) was added to the dispersion vehicle as the adhesion improvement agent. A concentration of the adhesion improvement agent was 2 mass%. A conductive film was formed on a board under the same conditions as Example 9 except for the above-described changes. The conductive film thus formed had sheet resistance of 280 mΩ/sq. The conductive film was not peeled off in the peel test.

### [Example 11]

Ethylene glycol was used as the dispersion vehicle. Copper particulates having an average particle diameter of 100 nm were used. The obtained copper particulate dispersion was in the form of a paste. The copper particulate dispersion was coated on a board by a drawdown method to form a film having a film thickness of 2 µm. A conductive film was formed on a board under the same conditions as Example 10 except for the above-described changes. The conductive film thus formed had sheet resistance of 450 mΩ/sq. The conductive film was not peeled off in the peel test.

### [Example 12]

Copper particulates having an average particle diameter of 1500 nm were used. A concentration of the copper particulates was 60 mass%. The obtained copper particulate dispersion was in the form of a paste. A conductive film was formed on a board under the same conditions as Example 11 except for the above-described changes. The conductive film thus formed had sheet resistance of 200 mΩ/sq. The conductive film was not peeled off in the peel test.

### [Example 13]

Copper particulates having an average particle diameter of 50 nm were used. A concentration of the copper particulates was 80 mass%. The obtained copper particulate dispersion was in the form of a paste. A conductive film was formed on a board under the same conditions as Example 12 except for the above-described changes. The conductive film thus formed had sheet resistance of 250 mΩ/sq. The conductive film was not peeled off in the peel test.

### [Example 14]

A board comprising quartz glass was used. A conductive film was formed on the board under the same conditions as Example 5 except for the above-described change. The conductive film thus formed had sheet resistance of 270 mΩ/sq. The conductive film was not peeled off in the peel test.

### [Example 15]

A glass slide was used as a board. A conductive film was formed on the board under the same conditions as Example 14 except for the above-described change. The conductive film thus formed had sheet resistance of 290 mΩ/sq. The conductive film was not peeled off in the peel test.

### [Example 16]

A silicon wafer was used as a board. The energy of light irradiation was changed to 17 J/cm². A conductive film was formed on the board under the same conditions as Example 15 except for the above-described changes. The conductive film thus formed had sheet resistance of 500 mΩ/sq. The conductive film was not peeled off in the peel test.

### [Example 17]

An aluminum foil was used as a board. The energy of light irradiation was changed to 10 J/cm². A conductive film was formed on the board under the same conditions as Example 16 except for the above-described changes. The conductive film was formed because an appearance of the film changed to that of a metal copper by the light irradiation. Since the board was conductive, sheet resistance of the formed conductive film was not measured due to the measurement condition. The conductive film was not peeled off in the peel test.

### [Example 18]

Ceramics (alumina) was used as a board. The energy of light irradiation was changed to 8 J/cm². A conductive film was formed on the board under the same conditions as Example 16 except for the above-described changes. The conductive film thus formed had sheet resistance of 500 mΩ/sq. The conductive film was not peeled off in the peel test.

### (Comparative Example 1)

No adhesion improvement agent was added to the dispersion vehicle. Other conditions were the same as Example 5. An appearance of the film was changed to that of a metal copper, but adhesiveness of the conductive film was not attained, and it was impossible to form the conductive film on the board.

### (Comparative Example 2)

No adhesion improvement agent was added to the dispersion vehicle. Other conditions were the same as Example 15. An appearance of the film was changed to that of a metal copper, but adhesiveness of the conductive film was not attained, and it was impossible to form the conductive film on the board.

### (Comparative Example 3)

No adhesion improvement agent was added to the dispersion vehicle. Other conditions were the same as Example 14. An appearance of the film was changed to that of a metal copper, but adhesiveness of the conductive film was not attained, and it was impossible to form the conductive film on the board.

### (Comparative Example 4)

No adhesion improvement agent was added to the dispersion vehicle. Other conditions were the same as Example 16. An appearance of the film was changed to that of a metal copper, but adhesiveness of the conductive film was not attained, and it was impossible to form the conductive film on the board.

### (Comparative Example 5)

No adhesion improvement agent was added to the dispersion vehicle. Other conditions were the same as Example 17. An appearance of the film was changed to that of a metal copper, but adhesiveness of the conductive film was not attained, and it was impossible to form the conductive film on the board.

### (Comparative Example 6)

No adhesion improvement agent was added to the dispersion vehicle. Other conditions were the same as Example 18. An appearance of the film was changed to that of a metal copper, but adhesiveness of the conductive film was not attained, and it was impossible to form the conductive film on the board.

As indicated by Examples 1 to 18, the use of the adhesion improvement agent enables the conductive film having favorable adhesiveness to be formed on the board comprising the inorganic substrate. In the case where the adhesion improvement agent is not used, the appearance of the film changes to that of the metal copper, but adhesiveness of the conductive film was not attained as is indicated by Comparative Examples 1 to 6.

The present invention is not limited to the configurations of the above-described embodiments and can be modified within the scope which does not deviate from the subject-matter of the invention. For example, the shape of the inorganic substrate 3 is not limited to the plate-like shape and may be an arbitrarily-selected three-dimensional shape.

### [Reference Numerals and Signs]

- 1: copper particulate dispersion
- 11: copper particulates
- 2: film
- 3: inorganic substrate
- 4: conductive film

## Claims

1. Copper particulate dispersion comprising a dispersion vehicle and copper particulates dispersed into the dispersion vehicle, **characterized in that**:
the copper particulate dispersion comprises an adhesion improvement agent which improves adhesiveness between a conductive film formed on a substrate by photo-sintering the copper particulates and the substrate;
the substrate is an inorganic substrate; and
the adhesion improvement agent is a compound containing a phosphorus atom.

2. The copper particulate dispersion according to claim 1, **characterized in that** the inorganic substrate is selected from the group consisting of glass, ceramics, a silicon wafer, and aluminum.

3. The copper particulate dispersion according to claim 1 or claim 2, **characterized in that** the adhesion improvement agent is added to the dispersion vehicle.

4. The copper particulate dispersion according to claim 3, **characterized in that** the adhesion improvement agent is selected from the group consisting of hydroxyethylidene diphosphonic acid, ethylenediaminetetramethylene phosphonic acid, phosphoric acid, tetrabutylphosphonium sulfate, octylphosphonic acid, and a polymer containing a phosphorus atom.

5. The copper particulate dispersion according to claim 3, **characterized in that** the adhesion improvement agent has a function of dispersing the copper particulates into the dispersion vehicle.

6. The copper particulate dispersion according to claim 5, **characterized in that** the adhesion improvement agent is selected from the group consisting of phosphoric acid esters and high molecular weight phosphoric acid esters.

7. The copper particulate dispersion according to claim 1 or claim 2, **characterized in that** the dispersion vehicle comprises a compound containing a phosphorus atom.

8. A conductive film forming method **characterized by** comprising:
a step for forming a film of the copper particulate dispersion defined in any one of claims 1 to 7 on an inorganic substrate and
a step for forming a conductive film by photo-sintering the copper particulates in the film through irradiation of the film with light.

9. A circuit board **characterized by** comprising a circuit which comprises a conductive film formed by the conductive film forming method defined in claim 8 on a board comprising an inorganic substrate.

## Amended claims

### Amended claims under Art. 19.1 PCT

**1.** (Amended) Copper particulate dispersion comprising a dispersion vehicle and copper particulates dispersed into the dispersion vehicle, **characterized in that**:
the copper particulate dispersion comprises an adhesion improvement agent which improves adhesiveness between a conductive film formed on a substrate by photo-sintering the copper particulates and the substrate;
the substrate is an inorganic substrate; and
the adhesion improvement agent is added to the dispersion vehicle, and it is a compound containing a phosphorus atom selected from the group consisting of hydroxyethylidene diphosphonic acid, ethylenediaminetetramethylene phosphonic acid, phosphoric acid, tetrabutylphosphonium sulfate, and octylphosphonic acid.

**2.** The copper particulate dispersion according to claim 1, **characterized in that** the inorganic substrate is selected from the group consisting of glass, ceramics, a silicon wafer, and aluminum.

**3.** (Canceled)

**4.** (Canceled)

**5.** (Canceled)

**6.** (Canceled)

**7.** (Canceled)

**8.** (Amended) A conductive film forming method **characterized by** comprising:
a step for forming a film of the copper particulate dispersion defined in claim 1 or claim 2 on an inorganic substrate and
a step for forming a conductive film by photo-sintering the copper particulates in the film through irradiation of the film with light.

**9.** (Amended) A circuit board **characterized by** comprising a circuit which comprises a conductive film formed by the conductive film forming method defined in claim 3 on a board comprising an inorganic substrate.

Statement under Art. 19.1 PCT
In Claim 1, a compound containing a phosphorus atom selected from the group consisting of hydroxyethylidene diphosphonic acid, ethylenediaminetetramethylene phosphonic acid, phosphoric acid, tetrabutylphosphonium sulfate, and octylphosphonic acid is added to the dispersion vehicle.

It is not described in the cited reference that the above-described compound is added to the dispersion vehicle.

The present invention achieves an effect that by adding the above-described compound containing a phosphorus atom to the dispersion vehicle, adhesiveness is improved between a conductive film formed on a substrate by photo-sintering the copper particulates and the substrate.
